# EUROPÄISCHE PATENTSCHRIFT

(11) **EP 2 608 375 B1**
(45) Veröffentlichungstag und Bekanntmachung des Hinweises auf die Patenterteilung: **05.09.2018**
(21) Anmeldenummer: 12198645.9
(22) Anmeldetag: 20.12.2012
(51) Int. Cl.: H02J 3/38, H02M 1/32, H02M 7/5387, G01R 31/327

(54) **SCHALTUNGSANORDNUNG MIT EINEM WECHSELRICHTER UND VERFAHREN ZUR FUNKTIONSPRÜFUNG VON ELEKTROMECHANISCHEN SCHALTERN**
Circuit arrangement with an inverter and method for testing the functionality of electromechanical switches
Agencement de commutation doté d'un onduleur et procédé de vérification du fonctionnement de commutateurs électromécaniques

(30) Priorität: 23.12.2011 DE 102011122359
(43) Veröffentlichungstag der Anmeldung: 26.06.2013
(73) Patentinhaber: Kostal Industrie Elektrik GmbH, 58513 Lüdenscheid (DE)
(72) Erfinder: Bartling, Ralf. Dr., 58730 Fröndenberg (DE)
(74) Vertreter: Kerkmann, Detlef

(56) Entgegenhaltungen:
- EP-A2- 2 515 404
- WO-A1-2008/108770
- DE-A1-102009 047 980
- US-A- 4 761 704
- US-A- 5 625 539
- US-A1- 2010 226 160
- US-A1- 2011 298 470

## Beschreibung

Die Erfindung betrifft eine Schaltungsanordnung mit einem Wechselrichter gemäß dem Oberbegriff des Anspruchs 1 und ein Verfahren zur Funktionsprüfung von elektromechanischen Schaltern in der Schaltungsanordnung.

Anlagen zur Umwandlung regenerativer Energien, wie zum Beispiel Windkraft- oder Photovoltaikanlagen weisen zumeist einen Wechselrichter auf, welcher eine Spannung in der Höhe und Frequenz der üblichen Netzwechselspannung ausgibt. Dabei ist es zumeist vorgesehen, die elektrische Ausgangsleistung des Wechselrichters ganz oder teilweise in ein öffentliches Spannungsnetz einzuspeisen.

Für netzgekoppelte Wechselrichter ist eine Trennvorrichtung zur sicheren Trennung vom Netz vorgeschrieben. Diese Trennvorrichtung soll sowohl bei Fehlern im Wechselrichter als auch bei Netzfehlern eine sichere Trennung des Wechselrichters vom Netz gewährleisten. Dazu eignet sich vorteilhaft ein elektromechanischer Schalter, beispielsweise ein Relais oder Schütz, der die stromführenden Leiter des Wechselrichters, das heißt die Phasenleiter und vorzugsweise auch den Neutralleiter, über Schaltkontakte mit den entsprechenden Leitern des Spannungsnetzes verbindet beziehungsweise trennt. Alternativ können auch mehrere elektromechanische Schalter vorgesehen sein, die die stromführenden Leiter des Wechselrichters einzeln mit den entsprechenden Leitern des Spannungsnetzes verbinden beziehungsweise trennen.

Aus der US 2010/0226160 A1 ist eine gattungsgemäße Wechselrichterschaltung mit einer Trennvorrichtung bekannt, wobei die Trennvorrichtung eine Anordnung aus mindestens drei elektromechanischen Schaltern aufweist.

Ein elektromechanischer Schalter stellt allerdings selbst eine potentielle Fehlerquelle dar. So kann es vorkommen, dass der Schalter insgesamt ausfällt, oder dass einzelne Schaltkontakte nicht schließen oder umgekehrt im geschlossenen Zustand "hängenbleiben". Solche Fehler können zu Sachschäden führen oder sogar Menschenleben gefährden. Aus diesem Grund ist es vorgeschrieben, dass ein Wechselrichter mit einer internen Trennstelle bei jedem Start überprüft, ob diese Trennstelle noch vorschriftsmäßig arbeitet.

Es stellte sich die Aufgabe, eine gattungsgemäße Schaltungsanordnung, die sich durch eine besonders hohe Zuverlässigkeit und Testbarkeit auszeichnet, sowie ein vorteilhaftes Verfahren zur Funktionsprüfung von elektromechanischen Schaltern in der Schaltungsanordnung zu schaffen.

Diese Aufgabe wird zum einen durch die Schaltanordnung nach Anspruch 1 gelöst, wobei vorgesehen ist, dass die Reihenschaltungen der Schaltkontakte jeweils aus einem ersten Schaltkontakt und einem zweiten Schaltkontakt bestehen, wobei alle ersten Schaltkontakte zu einem ersten elektromechanischen Schalter gehören, und alle zweiten Schaltkontakte zu einem zweiten elektromechanischen Schalter gehören, und dass die Steuervorrichtung beim Einschalten und/oder beim Ausschalten des Wechselrichters die elektromechanischen Schalter wechselweise ansteuert und die Spannungen auf den Phasenleitern erfasst. Zum anderen wird die Aufgabe durch die in den Ansprüchen 9 bis 11 beschriebene Prüfverfahren gelöst.

Die erfindungsgemäße Schaltungsanordnung und das dazu vorgeschlagene Prüfverfahren sollen im Folgenden anhand der Zeichnung dargestellt und näher erläutert werden. Es zeigen
- Figur 1: ein Blockschaltbild der Schaltungsanordnung,
- Figur 2: ein Spannungsmessverfahren,
- Figur 3: einen Prüfablauf vor dem Start des Wechselrichters,
- Figur 4: einen Prüfablauf vor dem Stop des Wechselrichters,
- Figur 5: eine vorteilhafte Erweiterung der in der Figur 1 dargestellten Schaltungsanordnung.

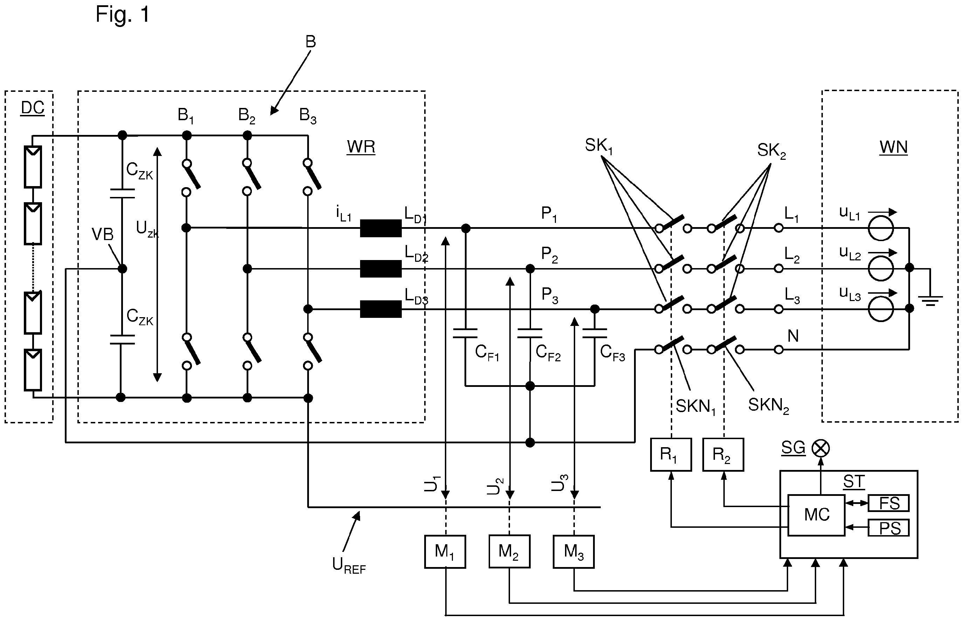

Die Figur 1 zeigt in schematischer Weise eine erfindungsgemäß aufgebaute Schaltungsanordnung. Die Schaltungsanordnung weist einen Wechselrichter WR auf, an dessen Zwischenkreis eine Gleichspannungsquelle DC anschließbar ist. Als Gleichspannungsquelle DC ist hier beispielhaft eine Reihenschaltung aus mehreren Solarmodulen (Panels) dargestellt, die vereinfachend für die spannungserzeugenden Elemente einer Photovoltaikanlage stehen.

Die von der Gleichspannungsquelle DC in den Wechselrichter WR eingespeiste so genannte Zwischenkreisspannung U_{ZK} liegt innerhalb des Wechselrichters WR an einer Reihenschaltung aus zwei Zwischenkreiskondensatoren C_{ZK} an, welche die dem Wechselrichter WR zugeführte elektrische Energie Zwischenspeichern. Mit den Zwischenkreiskondensatoren C_{ZK} verbunden ist eine Schaltbrücke B, die aus drei Brückenzweigen B₁, B₂, B₃ besteht. Die dargestellten Schaltersymbole stehen vereinfachend für steuerbare Leistungshalbleiterschalter.

Mit den Brückenzweigen B₁, B₂, B₃ ist jeweils eine Glättungsinduktivität L_{D1}, L_{D2}, L_{D3} verbunden, deren Ausgangleitungen die drei Phasenleiter P₁, P₂, P₃ des Wechselrichters WR bilden, welche über die Schaltkontakte SK₁, SK₂ zweier Relais R₁, R₂ mit den drei Phasenleitern L₁, L₂, L₃ eines Wechselspannungsnetzes WN verbindbar sind. Zusätzlich ist durch zwei Schaltkontakte SKN₁, SKN₂ der Verbindungspunkt VB der beiden Zwischenkreiskondensatoren C_{ZK} des Wechselrichters WR auf den Neutralleiter N des Wechselspannungsnetzes WN schaltbar. Statt der beiden hier dargestellten Relais R₁, R₂ können alternativ auch mehr als zwei elektromechanische Schalter vorgesehen sein, welche die Schaltkontakte SK₁, SK₂, SKN₁, SKN₂ betätigen. So kann beispielsweise für jeden der insgesamt acht Schaltkontakte SK₁, SK₂, SKN₁, SKN₂ jeweils ein eigenes den jeweiligen Schaltkontakt betätigendes Relais vorgesehen sein. In diesem Fall kommen also insgesamt acht Relais zur Anwendung, von denen jeweils vier gemeinsam gesteuert werden.

An die Phasenleiter P₁, P₂, P₃ ist jeweils ein Anschluss eines Kondensators C_{F1}, C_{F2}, C_{F3} angebunden. Die freien Anschlüsse der Kondensatoren C_{F1}, C_{F2}, C_{F3}, sind elektrisch zusammengeführt und liegen gemeinsam an dem Verbindungspunkt VB der Zwischenkreiskondensatoren C_{ZK} an. Die Kondensatoren C_{F1}, C_{F2}, C_{F3} bilden zusammen ein Netzfilter aus, welches die Einspeisung von sinusförmigen Strömen in das Wechselspannungsnetz WN sicherstellt.

Zur Ansteuerung der beiden Relais R₁, R₂, welche die Schaltkontakte SK₁, SK₂ betätigen und von denen jeweils zwei Schließerkontakte in Reihe geschaltet sind, ist eine Steuervorrichtung ST vorgesehen, welche mindestens einen Mikrocontroller MC, einen Programmspeicher PS und einen Fehlerspeicher FS aufweist. Der Programmspeicher PS enthält den Programmcode der vom Mikrocontroller MC zu steuernden Abläufe. Der Mikrocontroller MC kann insbesondere auch die Ansteuerung der in den Brückenzweigen B₁, B₂, B₃ des Wechselrichters WR angeordneten steuerbaren Halbleiterschalter vornehmen, was hier aber nicht näher ausgeführt werden soll.

Auf jeden Fall steuert der Mikrocontroller MC die beiden Relais R₁, R₂, um die als Schließerkontakte ausgeführten Schaltkontakte SK₁, SKN₁, SK₂, SKN₂ zu betätigen. Durch das Schließen der Schaltkontakte SK₁, SKN₁, SK₂, SKN₂ werden die Phasenleiter P₁, P₂, P₃ des Wechselrichters WR mit den drei Phasenleitern L₁, L₂, L₃ des Wechselspannungsnetzes WN verbunden. Des Weiteren wird das Potential des Verbindungspunkts VB der Zwischenkreiskondensatoren C_{ZK} mit dem Neutralleiter N des Wechselspannungsnetzes WN verbunden. Beendet die Steuervorrichtung ST die Ansteuerung der Relais R₁, R₂, so öffnen alle Schaltkontakte SK₁, SK₂, SKN₁, SKN₂ und die vorgenannten Verbindungen werden getrennt.

Die Verwendung von mindestens zwei unabhängigen elektromechanischen Schaltern, die hier als Relais R₁, R₂ bezeichnet sind, von denen jeweils zwei Schaltkontakte SK₁, SK₂, SKN₁, SKN₂ in Reihe geschaltet sind, schaffen eine Redundanz und dadurch ein erhöhtes Sicherheitslevel, beispielsweise für den Fall einer Notabschaltung, bei der jedes Relais R₁, R₂ die Verbindungen zwischen dem Wechselrichter WR und dem Spannungsnetz WN trennen kann und ist durch die aktuell gültige Normenlage zwingend vorgeschrieben.

Zum Erreichen einer hohen Funktionssicherheit ist allerdings sicherzustellen, dass die elektromechanischen Schalter R₁, R₂ fehlerfrei funktionieren. Die redundante Anordnung von Relais R₁, R₂ schafft zusätzliche Fehlermöglichkeiten, etwa wenn eine Relaismechanik gestört ist oder wenn einzelne Schaltkontakte SK₁, SK₂, SKN₁, SKN₂ keine elektrische Verbindung herstellen können, oder umgekehrt ständig in der geschlossenen Schaltstellung verbleiben.

Die Steuervorrichtung ST führt daher verschiedene Prüfabläufe aus, die einzeln oder in Kombination ein Prüfverfahren für die Schaltungsanordnung und zwar insbesondere hinsichtlich des korrekten Funktionierens der Relais R₁, R₂ und der Schaltkontakte SK₁, SK₂, SKN₁, SKN₂ darstellen. Die Steuervorrichtung ST steuert dazu die Relais R₁, R₂ nach einem vorgegebenen Schema sequentiell an und vergleicht dabei die auf den Phasenleitern P₁, P₂, P₃ auftretenden Werte der Spannungen U₁, U₂, U₃ mit jeweils zu erwartenden Spannungshöhen. Dazu sind Messvorrichtungen M₁, M₂, M₃ vorgesehen, welche die Spannungswerte U₁, U₂, U₃ relativ zu einem Referenzpotential U_{REF} erfassen. Die von den Messvorrichtungen M₁, M₂, M₃ erfassten Messwerte werden der Steuervorrichtung ST zugeführt und durch den Mikrocontroller MC verarbeitet. Erkennt der Mikrocontroller MC einen Fehler, so wird ein den Fehler repräsentierender Wert in einen Fehlerspeicher FS geschrieben. Des Weiteren wird der Fehler durch einen Signalgeber SG, ausgebildet beispielsweise als eine Signalleuchte oder ein Display, signalisiert. Der Inhalt des Fehlerspeichers FS beeinflusst darüber hinaus den weiteren Betrieb der Schaltungsanordnung. So kann ein gesetzter Fehlerspeicher FS beispielsweise eine Abschaltung des Wechselrichters WR bewirken.

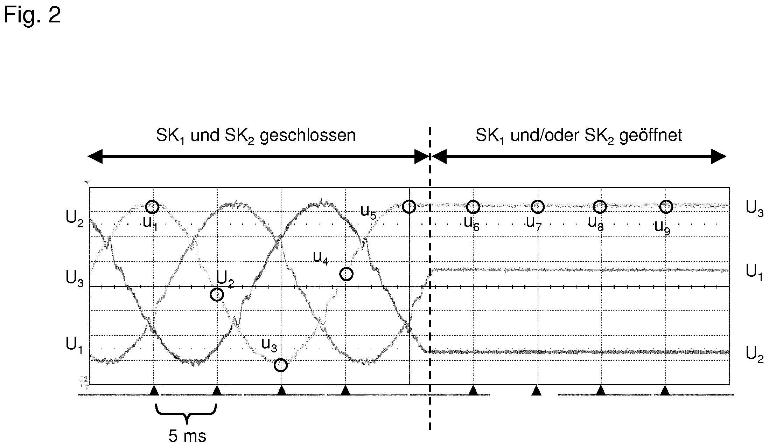

Unter Bezugnahme auf die in den Figuren 2 bis 4 dargestellten Diagrammen, welche zeitliche Abfolgen verschiedener Spannungs- und Signalwerte darstellen, sollen nachfolgend typische Prüfabläufe stichwortartig skizziert werden. Hierbei prüft die Steuervorrichtung ST insbesondere die Funktionsfähigkeit der beiden Relais R₁, R₂ und der zugehörigen Schaltkontakte SK₁, SK₂, SKN₁, SKN₂.

Figur 2 skizziert den Ablauf der Erfassung der Spannungen U₁, U₂, U₃ auf den Phasenleitern P₁, P₂, P₃, die durch die Steuervorrichtung ST mit Hilfe der Messvorrichtungen M₁, M₂, M₃ ausgeführt wird. Das Prüfkriterium wird dabei auf *alle* Phasen angewandt. Die Figur 2 zeigt beispielhaft nur die Erfassung des Verlaufs der Spannung U₃ des Phasenleiters P₃. Es sei vorausgesetzt, dass der Wechselrichter WR zum Zeitpunkt der Messungen nicht aktiv ist; das bedeutet, dass die Halbleiterschalter in den Brückenzweigen B₁, B₂, B₃ nicht getaktet angesteuert werden, sondern geöffnet sind. Der Wechselrichter WR liefert somit keinen Beitrag zu den Spannungen U₁, U₂, U₃ auf den Phasenleitern P₁, P₂, P₃.

Beim Messvorgang sind grundsätzlich zwei Situationen zu unterscheiden. Sind beide Relais R₁, R₂ durch die Steuervorrichtung ST angesteuert und folglich in jeder Phase die in Reihe liegenden Schaltkontakte SK₁, SK₂ geschlossen, so liegt an der Messvorrichtung M₁, M₂, M₃ jedes Phasenleiters P₁, P₂, P₃, das Potential der jeweiligen Phase L₁, L₂, L₃ des Wechselspannungsnetzes WN an. Es ergibt sich folglich an den Messvorrichtungen M₁, M₂, M₃ ein idealerweise sinusförmiger Spannungsverlauf. Ist dagegen wenigstens einer der Schaltkontakte SK₁, SK₂ geöffnet, weil das zugehörige Relais R₁, R₂ nicht angesteuert ist oder weil an einem Relais R₁, R₂ etwa die Magnetspule, die Mechanik oder der jeweilige Schaltkontakt SK₁, SK₂ defekt ist, so hat der Spannungsverlauf der jeweiligen Phase L₁, L₂, L₃ des Spannungsnetzes WN keinen Einfluss. Statt dessen wirkt die mit dem jeweiligen Phasenleiter P₁, P₂, P₃ verbundenen Kapazität C_{F1}, C_{F2}, C_{F3} nun spannungseinprägend, das heißt die jeweilige Messvorrichtung M₁, M₂, M₃ erfasst eine im wesentlichen konstante Spannung, entsprechend dem aktuellen Ladezustand des jeweiligen Kondensators C_{F1}, C_{F2}, C_{F3}.

Die Messvorrichtungen M₁, M₂, M₃ erfassen die Spannungen U₁, U₂, U₃ auf den einzelnen Phasenleitern P₁, P₂, P₃ in einem festen Zeitabstand von hier beispielhaft 5 ms. Die Steuervorrichtung ST überprüft für jeden Phasenleiter P₁, P₂, P₃ die Spannungsänderungen Δu = uₙ₊₁-uₙ zwischen den Abtastzeitpunkten. Überschreiten die Spannungsänderungen Δu an wenigstens einem der Phasenleiter P₁, P₂, P₃ einen vorgegebenen Schwellenwert, so folgt daraus, dass der entsprechende Phasenleiter P₁, P₂, P₃ mit der entsprechenden Phase L₁, L₂, L₃ des Wechselspannungsnetzes WN verbunden ist und daher beide Schaltkontakte SK₁, SK₂ der entsprechenden Phase geschlossen sind.

Bei einem im Wesentlichen konstanten erfassten Spannungswert sind die zeitlichen Spannungsänderungen Δu = uₙ₊₁-uₙ entsprechend gering. Da die Spannungsänderungen Δu den vorgegebene Schwellenwert nicht überschreiten, erkennt die die Steuervorrichtung ST, dass mindestens einer der Schaltkontakte SK₁, SK₂ der jeweiligen Phase L₁, L₂, L₃ geöffnet oder unterbrochen ist.

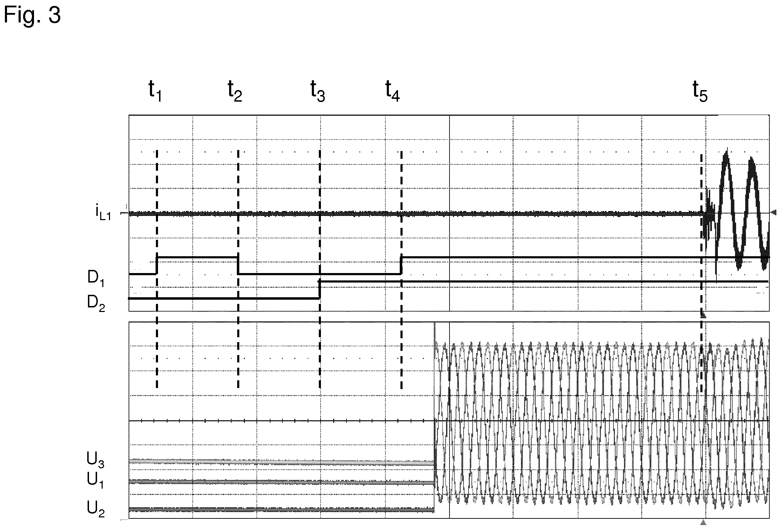

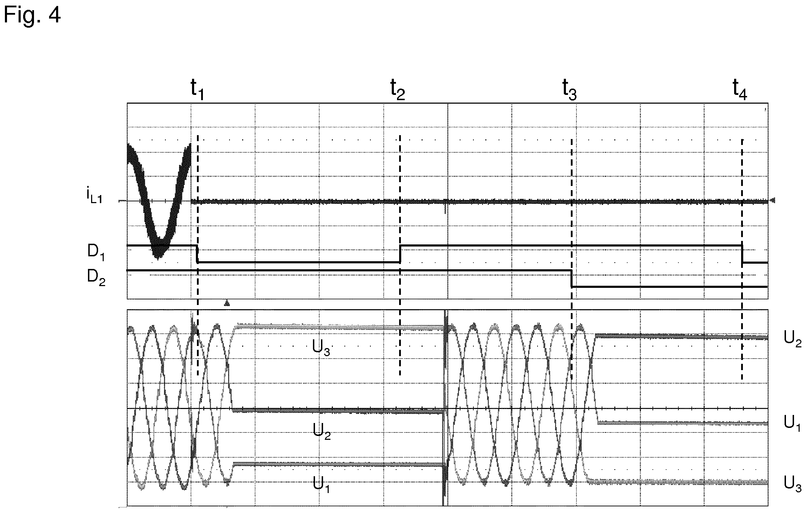

Diese Methode zur Spannungserfassung wird bei den beiden anhand der Figuren 3 und 4 beschriebenen Prüfverfahren verwendet. Die Figur 3 verdeutlicht ein Prüfverfahren, welches die in der Figur 1 dargestellte Schaltungsanordnung vorzugsweise jeweils vor dem Start des Wechselrichters WR ausführt. Zur Verdeutlichung der Aktivität des Wechselrichters WR zeigt die Kurve i_{L1} den Stromverlauf auf dem ersten Phasenleiter P1 an. Das Prüfverfahren besteht aus den nachfolgend beschriebenen Verfahrensschritten.

Zu einem Zeitpunkt t₁ steuert die Steuervorrichtung ST das Relais R₁ an, so dass die Schaltkontakte SK₁ geschlossen werden. Die Signalverläufe D₁ und D₂ verdeutlichen die Ansteuerzustände der Relais R₁ und R₂, wobei ein Highpegel bedeutet, dass das entsprechende Relais R₁, R₂ durch die Steuervorrichtung ST angesteuert ist. Grundsätzlich weisen elektromechanische Schaltglieder eine endliche Schaltgeschwindigkeit auf. Daher werden im weiteren Verlauf alle Messungen erst 30 ms nach dem Schaltbefehl ausgeführt. Nach etwa 30 ms erfassen die Messvorrichtungen M₁, M₂, M₃ auf die zuvor beschriebene Weise die Spannungen U₁, U₂, U₃ an den Kondensatoren C_{F1}, C_{F2}, und C_{F3}. Für eine erfolgreiche Prüfung dürfen jetzt keine sinusförmigen Spannungen messbar sein.

Zum Zeitpunkt t₂ schaltet die Steuervorrichtung ST das Relais R₁ ab, wodurch die Schaltkontakte SK₁ wieder öffnen. Nach 30 ms erfassen die Messvorrichtungen M₁, M₂, M₃ wiederum die Spannungen U₁, U₂, U₃ an den Kondensatoren C_{F1}, C_{F2}, C_{F3}. Auch jetzt darf sich keine sinusförmige Spannung an den Messpunkten einstellen.

Zum Zeitpunkt t₃ steuert die Steuervorrichtung ST das Relais R₂ an, so dass die Schaltkontakte SK₂ geschlossen werden. Dreißig Millisekunden danach erfassen die Messvorrichtungen M₁, M₂, M₃ die Spannungen U₁, U₂, U₃ an den Kondensatoren C_{F1}, C_{F2}, C_{F3}. Genau wie bei der Prüfung von Relais R₁ darf sich auch hier keine sinusförmige Spannung einstellen.

Zu einem Zeitpunkt t₄ steuert die Steuervorrichtung ST das Relais R₁ erneut an, wodurch die Schaltkontakte SK₁ geschlossen werden. Wiederum 30 ms später erfassen die Messvorrichtungen M₁, M₂, M₃ die Spannungen U₁, U₂, U₃ an den Kondensatoren C_{F1}, C_{F2}, C_{F3}. Erst *jetzt* darf jeweils eine Wechselspannung an den Kondensatoren C_{F1}, C_{F2}, C_{F3} anliegen. Trifft dies zu, so wird die Funktionsprüfung als erfolgreich bewertet und es erfolgt die Freigabe der Taktung der Halbleiterschalter in den Brückenzweigen B₁, B₂, B₃ und damit der Start des Wechselrichters WR. Bei nicht erfolgreicher Funktionsprüfung, wird der Wechselrichter WR nicht gestartet. Stattdessen gibt der Signalgeber SG ein Fehlersignal aus und der Fehler wird im Fehlerspeicher FS abgelegt. Ein erneuter Start des Wechselrichters kann damit verhindert werden.

Die Figur 4 verdeutlicht einen Prüfablauf, welcher vor dem Herunterfahren der Schaltungsanordnung ausgeführt wird. Es sei vorausgesetzt, dass zum Beginn beide Relais R₁, R₂ angesteuert und daher sämtliche Schaltkontakte SK₁, SK₂, SKN₁, SKN₂, geschlossen sind. Der Wechselrichter befindet sich im Zustand der Netzeinspeisung.

Zu einem Zeitpunkt t₁ schaltet die Steuervorrichtung ST den Wechselrichter WR ab, in dem sie die Ansteuerung der Halbleiterschalter der Brückenzweige B₁, B₂, B₃ beendet. Eine Millisekunde später stellt die Steuervorrichtung ST die Ansteuerung des Relais R₁ ein. Nach weiteren 30 ms erfassen die Messvorrichtungen M₁, M₂, M₃ die Spannungen an den Kondensatoren C_{F1}, C_{F2}, C_{F3}. Aufgrund der geöffneten Schaltkontakte SK₁ der darf jetzt *keine* Wechselspannung aus dem Wechselspannungsnetz WN anliegen

Zu einem Zeitpunkt t₂ > t₁ schaltet die Steuervorrichtung ST das Relais R₁ wieder ein. Nach 30 ms erfassen die Messvorrichtungen M₁, M₂, M₃ die Spannungen an den Kondensatoren C_{F1}, C_{F2}, C_{F3}. Aufgrund der wieder geschlossenen Schaltkontakte SK₁ muss jetzt *eine* Wechselspannung anliegen. Damit ist die Funktionsfähigkeit von Relais R₁ nachgewiesen.

Zum Zeitpunkt t₃ > t₂ stellt die Steuervorrichtung ST die Ansteuerung des Relais R₂ ein. Nach 30 ms erfassen die Messvorrichtungen M₁, M₂, M₃ die Spannungen an den Kondensatoren C_{F1}, C_{F2}, C_{F3}. Aufgrund der nun geöffneten Schaltkontakte SK₂ darf jetzt wieder *keine* Wechselspannung anliegen. Damit ist auch die Funktionsfähigkeit von Relais R₂ nachgewiesen. Zum Zeitpunkt t₄ > t₃ beendet die Steuervorrichtung ST die Ansteuerung des Relais R₁. Da nun die alle Schaltkontakte SK₁, SK₂, SKN₁, SKN₂ geöffnet sein müssen, darf natürlich wiederum *keine* Wechselspannung von den Messvorrichtungen M₁, M₂, M₃ erfasst werden.

Sollte in einem dieser Schritte durch eine der Messvorrichtungen M₁, M₂, M₃ ein nicht erwarteter Spannungswert erfasst und damit durch den Mikrocontroller MC ein Fehler erkannt werden, so wird ein Fehlersignal im Fehlerspeicher FS abgelegt und durch den Signalgeber SG gemeldet. Aufgrund des abgespeicherten Fehlersignals wird ein Neustart des Wechselrichters WR nicht mehr zugelassen.

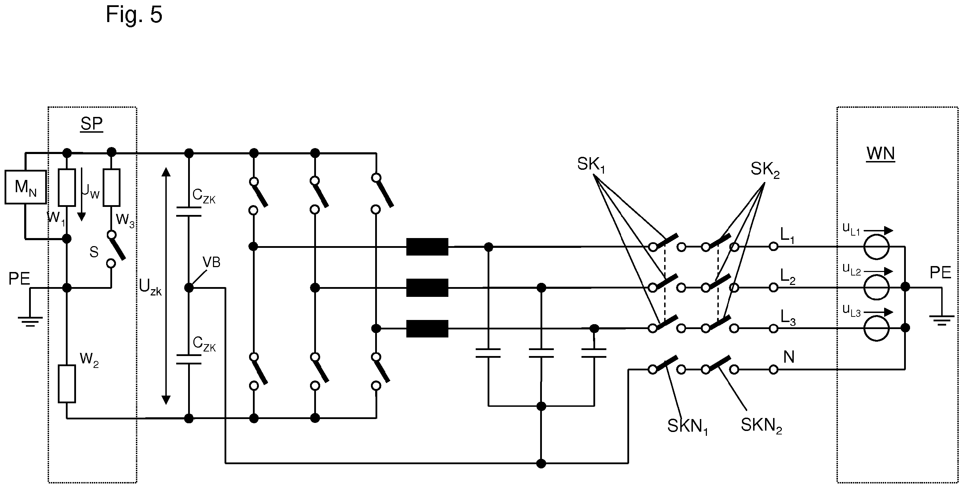

Die Figur 5 zeigt eine vereinfachte Darstellung der in der Figur 1 skizzierten Schaltungsanordnung mit einer vorteilhaften Schaltungsergänzung, durch die auch die Schaltkontakte SKN₁, SKN₂ der Relais R₁, R₂ in der mit dem Neutralleiter N verbundenen Leitung überprüfbar sind.

Hierzu ist eine Spannungsteileranordnung SP mit einem veränderbaren Teilungsverhältnis vorgesehen. Die Spannungsteileranordnung SP besteht zunächst aus der Reihenschaltung von zwei Widerständen W₁ und W₂, die mit dem Zwischenkreis des Wechselrichters WR verbunden ist, und an der daher die Zwischenkreisspannung U_{ZK} anliegt. Die Mitte des Spannungsteilers SP ist mit dem Erdpotential PE ("protective earth") verbunden.

Über einen, von der in dieser Figur nicht dargestellten Steuervorrichtung ST betätigbaren, steuerbaren Schalter S kann dem Widerstand W₁ ein weiterer Widerstand W₃ parallel geschaltet werden, wodurch sich das Teilungsverhältnis der Spannungsteileranordnung SP entsprechend der Werte der beteiligten Widerstände W₁, W₂, W₃ ändert. Im Folgenden sei rein beispielhaft angenommen, dass die drei Widerstände W₁, W₂, W₃ alle den gleichen Widerstandswert aufweisen.

In einem ersten Schritt des Prüfablaufs sind sowohl die beiden Schaltkontakte SKN₁, SKN₂ als auch der steuerbare Schalter S geöffnet. Aufgrund der durch die Widerstände W₁ und W₂ gebildeten symmetrischen Spannungsteileranordnung, erfasst eine zum Widerstand W₁ parallel angeordnete Messvorrichtung M_{N} eine Spannung in Höhe der halben Zwischenkreisspannung, das heißt einen Spannungswert von 1/2 U_{ZK}. Schließt nun die Steuervorrichtung ST den steuerbaren Schalter S, so sinkt, aufgrund des neuen Teilungsverhältnisses von 1:2 die von der Messvorrichtung M_{N} erfasste Spannung auf 1/3 U_{ZK}.

Ist dieser Teil des Prüfablaufs erfolgreich, so werden die Schaltkontakte SKN₁, SKN₂ nacheinander einzeln geschlossen. Hierbei darf sich die durch die Messvorrichtung M_{N} überwachte Spannung an den parallel geschalteten Widerstände W₁ und W₃ nicht verändern. An dieser Stelle sei vorausgesetzt, dass es sich bei dem Netz WN um ein TN-Netz bzw. TT-Netz handelt, das heißt, der Sternpunkt des Netzes ist geerdet und somit galvanisch fest mit dem Erdpotential PE verbunden.

Erst wenn die in der Neutralleitung N hintereinandergeschalteten Schaltkontakte SKN₁, SKN₂ zugleich geschlossen sind, darf sich eine Veränderung der durch die Messvorrichtung M_{N} erfassten Spannung ergeben. Über die Neutralleitung N des Wechselspannungsnetzes WN liegt dann das Erdpotential PE auch am Verbindungspunkt VB des Zwischenkreises an. Da das Erdpotential PE dadurch sowohl das Bezugspotential für die Mitte des Zwischenkreises als auch für die Mitte der Spannungsteileranordnung SP darstellt, liegt nun sowohl am Widerstand W₂ als auch an den zueinander parallelen Widerständen W₁ und W₃ jeweils die halbe Zwischenkreisspannung 1/2 U_{ZK} an.

Nach fehlerfreiem Schließen der beiden in Reihe geschalteten Schaltkontakte SKN₁, SKN₂ in der Neutralleitung N steigt somit die von der Messvorrichtung M_{N} erfasste Spannung von 1/3 U_{ZK} auf 1/2 U_{ZK} an. Dadurch sind sämtliche Schaltkontakte SK₁, SK₂, SKN₁, SKN₂, welche stromführende Leitungen P₁, P₂, P₃, N des Wechselrichters WR schalten, vollständig auf Fehlerfreiheit überprüfbar.

### Bezugszeichen

- B: Schaltbrücke
- B₁, B₂, B₃: Brückenzweige
- C_{F1}, C_{F2}, C_{F3}: Kapazitäten (Kondensatoren)
- C_{ZK}: Zwischenkreiskondensatoren
- DC: Gleichspannungsquelle
- D₁, D₂: Signalverläufe
- FS: Fehlerspeicher
- i_{L1}: Stromverlauf auf dem ersten Phasenleiter
- L₁, L₂, L₃: Phasen
- L_{D1}, L_{D2}, L_{D3}: Glättungsinduktivität
- M₁, M₂, M₃ M_{N}: Messvorrichtungen
- MC: Mikrocontroller
- N: Neutralleiter
- P₁, P₂, P₃: Phasenleiter
- PE: Erdpotential
- PS: Programmspeicher
- R₁, R₂: Relais (elektromechanische Schalter)
- S: steuerbarer Schalter
- SG: Fehlersignalgeber
- SK₁, SK₂, SKN₁, SKN₂: Schaltkontakte
- SP: Spannungsteileranordnung
- ST: Steuervorrichtung
- t₁, t₂, t₃, t₄, t₅: Zeitpunkte
- uₙ, uₙ₊₁: zeitlich nacheinander erfasste Spannungswerte
- Δu: Spannungsänderung(en)
- U₁, U₂, U₃, U_{w}: Spannungen
- U_{REF}: Referenzpotential
- U_{ZK}: Zwischenkreisspannung
- VB: Verbindungspunkt
- VK: Verknüpfungspunkt
- W₁, W₂, W₃: Widerstände
- WN: Wechselspannungsnetz
- WR: Wechselrichter

## Patentansprüche

1. Schaltungsanordnung
mit einem Wechselrichter (WR), dessen Zwischenkreis mit einer Gleichspannungsquelle (DC) verbindbar ist, und der eine dreiphasige Schaltbrücke (B) aufweist, deren ausgangsseitige Phasenleiter (P₁, P₂, P₃) mit den Phasen (L₁, L₂, L₃) eines dreiphasigen Wechselspannungsnetzes (WN) verbindbar sind, wobei jeder Phasenleiter (P₁, P₂, P₃) über eine Reihenschaltung aus zwei Schaltkontakten (SK₁, SK₂,) geführt ist, die zu verschiedenen elektromechanischen Schaltern (R₁, R₂) gehören, welche durch eine Steuervorrichtung (ST) ansteuerbar sind, wobei die Steuervorrichtung (ST) dazu eingerichtet ist, mittels Messvorrichtungen (M₁, M₂, M₃) Werte von Spannungen (U₁, U₂, U₃) auf den Phasenleitern (P₁, P₂, P₃) zu erfassen,
**dadurch gekennzeichnet,**
**dass** die Reihenschaltungen der Schaltkontakte (SK₁, SK₂,) jeweils aus einem ersten Schaltkontakt (SK₁) und einem zweiten Schaltkontakt (SK₂) bestehen, wobei alle ersten Schaltkontakte (SK₁) zu einem ersten elektromechanischen Schalter (R₁) gehören, und alle zweiten Schaltkontakte (SK₂) zu einem zweiten elektromechanischen Schalter (R₂) gehören, und
**dass** die Steuervorrichtung (ST) derart eingerichtet ist, dass sie beim Einschalten und/oder beim Ausschalten des Wechselrichters (WR) die elektromechanischen Schalter (R₁, R₂) wechselweise ansteuert und die Spannungen (U₁, U₂, U₃) auf den Phasenleitern (P₁, P₂, P₃) erfasst.

2. Schaltungsanordnung nach Anspruch 1, **dadurch gekennzeichnet, dass** ein Verbindungspunkt (VB) des Zwischenkreises über eine Reihenschaltung aus zwei Schaltkontakten (SKN₁, SKN₂) mit einem Neutralleiter (N) des Wechselspannungsnetzes (WN) verbindbar ist, wobei die Schaltkontakte (SKN₁, SKN₂) zu verschiedenen elektromechanischen Schaltern (R₁, R₂) gehören.

3. Schaltungsanordnung nach Anspruch 2, **dadurch gekennzeichnet, dass** die Steuervorrichtung (ST) dazu eingerichtet ist, mittels einer Messvorrichtung (M_{N}) einen Wert einer Spannung (U_{w}) an einer mit dem Zwischenkreis verbundenen Spannungsteileranordnung (SP) zu erfassen, wobei ein innerer Schaltungspunkt der Spannungsteileranordnung (SP) mit dem Erdpotential (PE) verbunden ist und wobei ein Teilungsverhältnis der Spannungsteileranordnung (SP) durch die Steuervorrichtung (ST) veränderbar ist.

4. Schaltungsanordnung nach Anspruch 1, **dadurch gekennzeichnet, dass** die Steuervorrichtung (ST) einen Mikrocontroller (MC) aufweist.

5. Schaltungsanordnung nach Anspruch 4, **dadurch gekennzeichnet, dass** die Schaltbrücke (B) mehrere Brückenzweige (B₁, B₂, B₃) mit steuerbaren Halbleiterschaltern aufweist, und dass der Mikrocontroller (MC) die Halbleiterschalter der Brückenzweige (B₁, B₂, B₃) steuert.

6. Schaltungsanordnung nach Anspruch 1, **dadurch gekennzeichnet, dass** zur Funktionsprüfung der elektromechanischen Schalter (R₁, R₂) die Steuervorrichtung (ST) die elektromechanischen Schalter (R₁, R₂) gemäß einem vorgegeben Prüfablauf steuert und die Spannungen (U₁, U₂, U₃) auf den Phasenleitern (P₁, P₂, P₃) erfasst.

7. Schaltungsanordnung nach Anspruch 3, **dadurch gekennzeichnet, dass** zur Funktionsprüfung der elektromechanischen Schalter (R₁, R₂) die Steuervorrichtung (ST) die elektromechanischen Schalter (R₁, R₂) gemäß einem vorgegeben Prüfablauf steuert und über eine Messvorrichtung (M_{N}) eine Spannung (U_{w}) an der Spannungsteileranordnung (SP) des Zwischenkreises erfasst.

8. Schaltungsanordnung nach Anspruch 1, **dadurch gekennzeichnet, dass** die elektromechanischen Schalter (R₁, R₂) als Relais oder Schütze ausgebildet sind.

9. Verfahren zur Funktionsprüfung von elektromechanischen Schaltern (R₁, R₂) in einer Schaltungsanordnung nach Anspruch 1, wobei vor dem Starten des Wechselrichters (WR) die Steuervorrichtung (ST) folgenden Prüfablauf steuert:
- Einschalten eines ersten Schaltkontakts (SK₁) jedes Phasenleiters (P₁, P₂, P₃) durch Ansteuerung eines ersten elektromechanischen Schalters (R₁) und Erfassung der Spannungen (U₁, U₂, U₃) auf den Phasenleitern (P₁, P₂, P₃) nach einer vorgegebenen Zeitspanne;
- Prüfung auf das Nichtvorhandensein einer Wechselspannung durch Erfassung und Vergleich zeitlich nacheinander erfasster Werte (uₙ, uₙ₊₁) der Spannungen (U₁, U₂, U₃) auf den Phasenleitern (P₁, P₂, P₃),
- Abschalten des ersten Schaltkontakts (SK₁) jedes Phasenleiters (P₁, P₂, P₃) durch Beenden der Ansteuerung des ersten elektromechanischen Schalters (R₁) und Erfassung der Spannungen (U₁, U₂, U₃) auf den Phasenleitern (P₁, P₂, P₃) nach einer vorgegebenen Zeitspanne,
- Prüfung auf das Nichtvorhandensein einer Wechselspannung durch Erfassung und Vergleich zeitlich nacheinander erfasster Werte (uₙ, uₙ₊₁) der Spannungen (U₁, U₂, U₃) auf den Phasenleitern (P₁, P₂, P₃),
- Einschalten eines zweiten Schaltkontakts (SK₂) jedes Phasenleiters (P₁, P₂, P₃) durch Ansteuerung eines zweiten elektromechanischen Schalters (R₂) und Erfassung der Spannungen (U₁, U₂, U₃) auf den Phasenleitern (P₁, P₂, P₃) nach einer vorgegebenen Zeitspanne,
- Prüfung auf das Nichtvorhandensein einer Wechselspannung durch Erfassung und Vergleich zeitlich nacheinander erfasster Werte (uₙ, uₙ₊₁) der Spannungen (U₁, U₂, U₃) auf den Phasenleitern (P₁, P₂, P₃),
- Einschalten des ersten Schaltkontakts (SK₁) jedes Phasenleiters (P₁, P₂, P₃) durch Ansteuerung des ersten elektromechanischen Schalters (R₁) und Erfassung der Spannungen (U₁, U₂, U₃) auf den Phasenleitern (P₁, P₂, P₃) nach einer vorgegebenen Zeitspanne,
- Prüfung auf das Vorhandensein einer Wechselspannung durch Erfassung und Vergleich zeitlich nacheinander erfasster Werte (uₙ, uₙ₊₁) der Spannungen (U₁, U₂, U₃) auf den Phasenleitern (P₁, P₂, P₃),
- Starten des Wechselrichters (WR), wenn alle vorgenannten Prüfschritte erfolgreich abgeschlossen wurden,
- Generierung eines Fehlersignals, wenn einer der vorgenannten Prüfschritte nicht erfolgreich abgeschlossen wurde.

10. Verfahren zur Funktionsprüfung von elektromechanischen Schaltern (R₁, R₂) in einer Schaltungsanordnung nach Anspruch 1, wobei nach dem Anhalten des Wechselrichters (WR) die Steuervorrichtung (ST) folgenden Prüfablauf steuert:
- Abschalten eines ersten Schaltkontakts (SK₁) jedes Phasenleiters (P₁, P₂, P₃) durch Beenden der Ansteuerung eines ersten elektromechanischen Schalters (R₁) und Erfassung der Spannungen (U₁, U₂, U₃) auf den Phasenleitern (P₁, P₂, P₃) nach einer vorgegebenen Zeitspanne,
- Prüfung auf das Nichtvorhandensein einer Wechselspannung durch Erfassung und Vergleich zeitlich nacheinander erfasster Werte (uₙ, uₙ₊₁) der Spannungen (U₁, U₂, U₃) auf den Phasenleitern (P₁, P₂, P₃),
- Einschalten des ersten Schaltkontakts (SK₁) jedes Phasenleiters (P₁, P₂, P₃) durch Ansteuerung des ersten elektromechanischen Schalters (R₁) und Erfassung der Spannungen (U₁, U₂, U₃) auf den Phasenleitern (P₁, P₂, P₃) nach einer vorgegebenen Zeitspanne,
- Prüfung auf das Vorhandensein einer Wechselspannung durch Erfassung und Vergleich zeitlich nacheinander erfasster Werte (uₙ, uₙ₊₁) der Spannungen (U₁, U₂, U₃) auf den Phasenleitern (P₁, P₂, P₃),
- Abschalten eines zweiten Schaltkontakts (SK₂) jedes Phasenleiters (P₁, P₂, P₃) durch Beenden der Ansteuerung eines zweiten elektromechanischen Schalters (R₂) und Erfassung der Spannungen (U₁, U₂, U₃) auf den Phasenleitern (P₁, P₂, P₃) nach einer vorgegebenen Zeitspanne,
- Prüfung auf das Nichtvorhandensein einer Wechselspannung durch Erfassung und Vergleich zeitlich nacheinander erfasster Werte (uₙ, uₙ₊₁) der Spannungen (U₁, U₂, U₃) auf den Phasenleitern (P₁, P₂, P₃),
- Abschalten des ersten Schaltkontakts (SK₁) jedes Phasenleiters (P₁, P₂, P₃) durch Beenden der Ansteuerung des ersten elektromechanischen Schalters (R₁),
- Generierung eines Fehlersignals, wenn einer der vorgenannten Prüfschritte nicht erfolgreich abgeschlossen wurde,
- im Falle eines aufgetreten Fehlers steuert die Steuervorrichtung (ST) einen Signalgeber (SG) zur Fehlersignalisierung an und speichert ein Fehlersignal in einem Fehlerspeicher (FS) ab, wobei bei einem gespeicherten Fehlersignal die Steuervorrichtung (ST) ein Neustarten des Wechselrichters (WR) nicht zulässt.

11. Verfahren zur Funktionsprüfung von elektromechanischen Schaltern (R₁, R₂) in einer Schaltungsanordnung nach Anspruch 7, wobei nach dem Anhalten des Wechselrichters (WR) die Steuervorrichtung (ST) folgenden Prüfablauf steuert:
- Steuerung eines ersten Schaltkontakts (SKN₁) eines ersten elektromechanischen Schalters (R₁) und eines zweiten Schaltkontakts (SKN₂) eines zweiten elektromechanischen Schalters (R₂) in den geöffneten Zustand,
- Erfassung einer Spannung (U_{W}) an einem Widerstand (W₁) der Spannungsteileranordnung (SP),
- Prüfung, ob die erfasste Spannung (U_{W}) dem durch das Teilungsverhältnis der Spannungsanordnung (SP) gegebenen Bruchteil der Zwischenkreisspannung (U_{ZK}) entspricht,
- Änderung des Teilungsverhältnisses der Spannungsteileranordnung (SP) durch Hinzuschalten eines Widerstands (W₃) mittels eines steuerbaren Schalters (S),
- Erfassung der Spannung (U_{W}) an dem Widerstand (W₁) der Spannungsteileranordnung (SP),
- Prüfung, ob die erfasste Spannung (U_{W}) dem durch das geänderte Teilungsverhältnis der Spannungsanordnung (SP) gegebenen Bruchteil der Zwischenkreisspannung (U_{ZK}) entspricht,
- Einschaltung des ersten Schaltkontakts (SKN₁) durch Ansteuerung des ersten elektromechanischen Schalters (R₁),
- Erfassung der Spannung (U_{W}) an dem Widerstand (W₁) der Spannungsteileranordnung (SP),
- Prüfung, ob die erfasste Spannung (U_{W}) unverändert ist,
- Abschaltung des ersten Schaltkontakts (SKN₁) durch Beenden der Ansteuerung des ersten elektromechanischen Schalters (R₁) und Einschaltung des zweiten Schaltkontakts (SKN₂) durch Ansteuerung des zweiten elektromechanischen Schalters (R₂),
- Erfassung der Spannung (U_{W}) an dem Widerstand (W₁) der Spannungsteileranordnung (SP),
- Prüfung, ob die erfasste Spannung (U_{W}) unverändert ist,
- Einschaltung des ersten Schaltkontakts (SKN₁) durch Ansteuerung des ersten elektromechanischen Schalters (R₁),
- Erfassung der Spannung (U_{W}) an dem Widerstand (W₁) der Spannungsteileranordnung (SP),
- Prüfung, ob die erfasste Spannung (U_{W}) einen Wert aufweist, der durch das am Mittenanschluss der Spannungsteileranordnung (SP) anliegenden Potential des Verbindungspunkts (VB) des Zwischenkreises gegeben ist,
- Speichern eines Fehlersignals, wenn einer der vorgenannten Prüfschritte nicht erfolgreich abgeschlossen wurde.

## Claims

1. Circuit configuration
having an inverter (WR) whose intermediate circuit can be connected to a direct current source (DC) and having a three-phase switching bridge (B) whose phase conductors (P₁, P₂, P₃) on the output side can be connected to the phases (L₁, L₂, L₃) of a three-phase alternating voltage network (WN), whereby each phase conductor (P₁, P₂, P₃) is run along a series circuit consisting of two switching contacts (SK₁, SK₂) that pertain to various electro-mechanical switches (R₁, R₂) which can be actuated by a control device (ST), whereby the control device (ST) is configured to record values of voltages (U₁, U₂, U₃) on the phase conductors (P₁, P₂, P₃) by means of measuring devices (M₁, M₂, M₃),
**characterised in that**
each of the series circuits of the switching contacts (SK₁, SK₂) is made up of a first switching contact (SK₁) and a second switching contact (SK₂), whereby all the first switching contacts (SK₁) pertain to a first electro-mechanical switch (R₁) and all the second switching contacts (SK₂) pertain to a second electro-mechanical switch (R₂), and
that the control device (ST) is configured in such a manner that, upon switching on or switching off the inverter (WR), it triggers the electro-mechanical switches (R₁, R₂) alternately and records the voltages (U₁, U₂, U₃) on the phase conductors (P₁, P₂, P₃).

2. Circuit configuration according to Claim 1, **characterised in that** a connection point (VB) of the intermediate circuit can be connected via a series circuit consisting of two switching contacts (SKN₁, SKN₂) to a neutral conductor (N) of the alternating voltage network (WN), whereby the switching contacts (SKN₁, SKN₂) pertain to different electro-mechanical switches (R₁, R₂).

3. Circuit configuration according to Claim 2, **characterised in that** the control device (ST) is configured for the purpose of recording, by means of a measuring device (M_{N}), a value of a voltage (U_{w}) on a voltage divider arrangement (SP) connected to the intermediate circuit, whereby an internal switching point of the voltage divider arrangement (SP) is connected to the earth potential (PE) and whereby a dividing ratio of the voltage divider arrangement (SP) can be modified by the control device (ST).

4. Circuit configuration according to Claim 1, **characterised in that** the control device (ST) has a microcontroller (MC).

5. Circuit configuration according to Claim 4, **characterised in that** the switching bridge (B) has a plurality of bridge arms (B₁, B₂, B₃) with controllable semiconductor switches and that the microcontroller (MC) controls the semiconductors of the bridge arms (B₁, B₂, B₃).

6. Circuit configuration according to Claim 1, **characterised in that**, for the purpose of testing the function of the electro-mechanical switches (R₁, R₂), the control device (ST) operates the electro-mechanical switches (R₁, R₂) according to a prescribed test sequence and records the voltages (U₁, U₂, U₃) on the phase conductors (P₁, P₂, P₃).

7. Circuit configuration according to Claim 3, **characterised in that**, for the purpose of testing the function of the electro-mechanical switches (R₁, R₂), the control device (ST) operates the electro-mechanical switches (R₁, R₂) according to a prescribed test sequence and records a voltage (U_{w}) on the voltage divider arrangement (SP) of the intermediate circuit by means of a measuring device (M_{N}).

8. Circuit configuration according to Claim 1, **characterised in that** the electro-mechanical switches (R₁, R₂) are formed as relays or contactors.

9. Procedure for testing the function of electro-mechanical switches (R₁, R₂) in a circuit configuration according to Claim 1, whereby the control device (ST) operates the following test sequence prior to starting the inverter (WR):
- Switching on a first switching contact (SK₁) of each phase conductor (P₁, P₂, P₃) by triggering a first electro-mechanical switch (R₁) and recording the voltages (U₁, U₂, U₃) on the phase conductors (P₁, P₂, P₃) after a prescribed time span;
- Checking for the non-existence of an alternating voltage by recording and comparing chronologically recorded values (uₙ, uₙ₊₁) of the voltages (U₁, U₂, U₃) on the phase conductors (P₁, P₂, P₃);
- Switching off the first switching contact (SK₁) of each phase conductor (P₁, P₂, P₃) by terminating the triggering of the first electro-mechanical switch (R₁) and recording the voltages (U₁, U₂, U₃) on the phase conductors (P₁, P₂, P₃) after a prescribed time span;
- Checking for the non-existence of an alternating voltage by recording and comparing chronologically recorded values (uₙ, uₙ₊₁) of the voltages (U₁, U₂, U₃) on the phase conductors (P₁, P₂, P₃);
- Switching on a second switching contact (SK₂) of each phase conductor (P₁, P₂, P₃) by triggering a second electro-mechanical switch (R₂) and recording the voltages (U₁, U₂, U₃) on the phase conductors (P₁, P₂, P₃) after a prescribed time span;
- Checking for the non-existence of an alternating voltage by recording and comparing chronologically recorded values (uₙ, uₙ₊₁) of the voltages (U₁, U₂, U₃) on the phase conductors (P₁, P₂, P₃);
- Switching on the first switching contact (SK₁) of each phase conductor (P₁, P₂, P₃) by triggering the first electro-mechanical switch (R₁) and recording the voltages (U₁, U₂, U₃) on the phase conductors (P₁, P₂, P₃) after a prescribed time span;
- Checking for the existence of an alternating voltage by recording and comparing chronologically recorded values (uₙ, uₙ₊₁) of the voltages (U₁, U₂, U₃) on the phase conductors (P₁, P₂, P₃);
- Starting the inverter (WR) once all the above specified test steps have been successfully completed;
- Generating an error signal if any of the above specified test steps has not been successfully completed.

10. Procedure for testing the function of electro-mechanical switches (R₁, R₂) in a circuit configuration according to Claim 1, whereby the control device (ST) operates the following test sequence after stopping the inverter (WR):
- Switching off a first switching contact (SK₁) of each phase conductor (P₁, P₂, P₃) by terminating the triggering of a first electro-mechanical switch (R₁) and recording the voltages (U₁, U₂, U₃) on the phase conductors (P₁, P₂, P₃) after a prescribed time span;
- Checking for the non-existence of an alternating voltage by recording and comparing chronologically recorded values (uₙ, uₙ₊₁) of the voltages (U₁, U₂, U₃) on the phase conductors (P₁, P₂, P₃);
- Switching on the first switching contact (SK₁) of each phase conductor (P₁, P₂, P₃) by triggering the first electro-mechanical switch (R₁) and recording the voltages (U₁, U₂, U₃) on the phase conductors (P₁, P₂, P₃) after a prescribed time span;
- Checking for the existence of an alternating voltage by recording and comparing chronologically recorded values (uₙ, uₙ₊₁) of the voltages (U₁, U₂, U₃) on the phase conductors (P₁, P₂, P₃);
- Switching off a second switching contact (SK₂) of each phase conductor (P₁, P₂, P₃) by terminating the triggering of a second electro-mechanical switch (R₂) and recording the voltages (U₁, U₂, U₃) on the phase conductors (P₁, P₂, P₃) after a prescribed time span;
- Testing for the non-existence of an alternating voltage by recording and comparing chronologically recorded values (uₙ, uₙ₊₁) of the voltages (U₁, U₂, U₃) on the phase conductors (P₁, P₂, P₃);
- Switching off the first switching contact (SK₁) of each phase conductor (P₁, P₂, P₃) by terminating the triggering of the first electro-mechanical switch (R₁);
- Generating an error signal if any of the above specified test steps has not been successfully completed;
- In the event of an error occurring, the control device (ST) triggers a signal transmitter (SG) to signalise the error and stores an error signal in an error memory (FS) whereby, in the event of a stored error signal, the control device (ST) does not allow a restart of the inverter (WR).

11. Procedure for testing the function of electro-mechanical switches (R₁, R₂) in a circuit configuration according to Claim 7, whereby the control device (ST) operates the following test sequence once the inverter (WR) has been stopped:
- Triggering a first switching contact (SKN₁) of a first electro-mechanical switch (R₁) and a second switching contact (SKN₂) of a second electro-mechanical switch (R₂) in its open state;
- Recording a voltage (U_{w}) on a resistor (W₁) of the voltage divider arrangement (SP);
- Checking whether the recorded voltage (U_{w}) corresponds to the fraction of the intermediate circuit voltage (U_{ZK}) resulting from the division ratio of the voltage arrangement (SP);
- Modifying the division ratio of the voltage divider arrangement (SP) by adding a resistor (W₃) by means of a controllable switch (S);
- Recording the voltage (U_{w}) on the resistor (W₁) of the voltage divider arrangement (SP);
- Checking whether the recorded voltage (U_{w}) corresponds to the fraction of the intermediate circuit voltage (U_{ZK}) resulting from the modified division ratio of the voltage arrangement (SP);
- Switching on the first switching contact (SKN₁) by triggering the first electro-mechanical switch (R₁);
- Recording the voltage (U_{w}) at the resistor (W₁) of the voltage divider arrangement (SP);
- Checking whether the recorded voltage (U_{w}) is unmodified;
- Switching off the first switching contact (SKN₁) by terminating the triggering of the first electro-mechanical switch (R₁) and switching on the second switching contact (SKN₂) by triggering the second electro-mechanical switch (R₂);
- Recording the voltage (U_{w}) at the resistor (W₁) of the voltage divider arrangement (SP);
- Checking whether the recorded voltage (U_{w}) is unmodified;
- Switching on the first switching contact (SKN₁) by triggering the first electro-mechanical switch (R₁);
- Recording the voltage (U_{w}) at the resistor (W₁) of the voltage divider arrangement (SP);
- Checking whether the recorded voltage (U_{w}) has a value that is given as a result of the potential of the connection point (VB) of the intermediate circuit applied to the centre connection of the voltage divider arrangement (SP);
- Storing an error signal if any of the above specified test steps has not been successfully completed.

## Revendications

1. Circuit de commutation
avec un onduleur (WR), dont le circuit intermédiaire peut être relié à une source de tension continue (DC), et qui présente un pont de commutation (B), dont les conducteurs de phases (P₁, P₂, P₃), côté sortie, peuvent être reliés aux phases (L₁, L₂, L₃) d'un réseau de tension alternative (WN), sachant que chacun des conducteurs de phases (P₁, P₂, P₃) est conduit, par le biais d'une installation en série à partir de deux contacts de commutation (SK₁, SK₂), qui sont associés à différents commutateurs électromécaniques (R₁, R₂), qui peuvent être commandés par un dispositif de commande (ST), sachant que le dispositif de commande (ST) est aménagé de manière à saisir, au moyen de dispositifs de mesure (M₁, M₂, M₃), des valeurs de tensions (U₁, U₂, U₃) sur le conducteurs de phases (P₁, P₂, P₃),
**caractérisé en ce que**
les installations en série des contacts de commutation (SK₁, SK₂) consistent chacune en un premier contact de commutation (SK₁) et en un deuxième contact de commutation (SK₂), sachant que tous les premiers contacts de commutation (SK₁) sont associés à un premier commutateur électromécanique (R₁) et que tous les deuxièmes contacts de commutation (SK₂) sont associés à un deuxième commutateur électromécanique (R₂), et
que le dispositif de commande (ST) est aménagé de manière à ce que, lors de la connexion et / ou de la déconnexion de l'onduleur (WR), il excite alternativement les commutateurs électromécaniques (R₁, R₂) et saisisse les tensions (U₁, U₂, U₃) sur les conducteurs de phases (P₁, P₂, P₃).

2. Circuit de commutation selon la revendication 1, **caractérisé en ce qu'**un point de liaison (VB) du circuit intermédiaire peut être relié à un conducteur neutre (N) du réseau de tension alternative (WN) par l'intermédiaire d'une installation en série à deux contacts de commutation (SKN₁, SKN₂), sachant que les contacts de commutation (SKN₁, SKN₂) sont associés à des commutateurs électromécaniques (R₁, R₂) différents.

3. Circuit de commutation selon la revendication 2, **caractérisé en ce que** le dispositif de commande (ST) est aménagé de manière à ce qu'il saisisse, au moyen d'un dispositif de mesure (M_{N}), une valeur de tension (U_{w}) sur un diviseur de tension (SP) qui est relié au circuit intermédiaire, sachant qu'un point de commutation intérieur du diviseur de tension (SP) est relié au potentiel terre (PE) et sachant qu'un rapport de division du diviseur de tension (SP) peut être modifié par le dispositif de commande (ST).

4. Circuit de commutation selon la revendication 1, **caractérisé en ce que** le dispositif de commande (ST) présente un microcontrôleur (MC).

5. Circuit de commutation selon la revendication 4, **caractérisé en ce que** le pont de commutation (B) présente plusieurs branches de pont (B₁, B₂, B₃) avec des commutateurs semi-conducteurs, et que le microcontrôleur (MC) commande les commutateurs semi-conducteurs des branches de pont (B₁, B₂, B₃).

6. Circuit de commutation selon la revendication 1, **caractérisé en ce que**, pour le contrôle du fonctionnement des commutateurs électromécaniques (R₁, R₂), le dispositif de commande (ST) commande les commutateurs électromécaniques (R₁, R₂) conformément à une marche de contrôle prédéterminée et saisit les tensions (U₁, U₂, U₃) sur les conducteurs de phases (P₁, P₂, P₃).

7. Circuit de commutation selon la revendication 3, **caractérisé en ce que**, pour le contrôle du fonctionnement des commutateurs électromécaniques (R₁, R₂), le dispositif de commande (ST) commande les commutateurs électromécaniques (R₁, R₂) conformément à une marche de contrôle prédéterminée et saisit une tension (U_{w}) sur le diviseur de tension (SP), par l'intermédiaire d'un dispositif de mesure (MN).

8. Circuit de commutation selon la revendication 1, **caractérisé en ce que** les commutateurs électromécaniques (R₁, R₂) sont réalisés sous la forme de relais ou de contacteurs-disjoncteurs.

9. Procédé de contrôle du fonctionnement de commutateurs électromécaniques (R₁, R₂) dans un circuit de commutation selon la revendication 1, sachant qu'avant le démarrage du l'onduleur (WR), le dispositif de commande (ST) commande le déroulement du contrôle suivant :
- connexion d'un premier contact de commutation ((SK₁) de chacun des conducteurs de phases (P₁, P₂, P₃) par excitation d'un premier commutateur électromécanique (R₁) et saisie de valeurs de tensions (U₁, U₂, U₃) sur les conducteurs de phases (P₁, P₂, P₃) selon un laps de temps prédéterminé,
- contrôle de l'absence d'une tension alternative par saisie et comparaison de valeurs (Uₙ, Un₊₁) de tensions (U₁, U₂, U₃) saisies successivement dans le temps sur les conducteurs de phases (P₁, P₂, P₃),
- déconnexion du premier contact de commutation (SK₁) de chacun des conducteurs de phases (P₁, P₂, P₃) par terminaison de l'excitation du premier commutateur électromécanique (R₁) et saisie des tensions (U₁, U₂, U₃) sur les conducteurs de phases (P₁, P₂, P₃) après un laps de temps prédéterminé,
- contrôle de l'absence d'une tension alternative par saisie et comparaison de valeurs (Uₙ, Un₊₁) de tensions (U₁, U₂, U₃) saisies successivement dans le temps sur les conducteurs de phases (P₁, P₂, P₃),
- connexion d'un deuxième contact de commutation (SK₂) de chacun des conducteurs de phases (P₁, P₂, P₃) par excitation d'un deuxième commutateur électromécanique (R₂) et saisie des tensions (U₁, U₂, U₃) sur les conducteurs de phases (P₁, P₂, P₃) après un laps de temps prédéterminé,
- contrôle de l'absence d'une tension alternative par saisie et comparaison de valeurs (Uₙ, Un₊₁) de tensions (U₁, U₂, U₃) saisies successivement dans le temps sur les conducteurs de phases (P₁, P₂, P₃)
- connexion du premier contact de commutation (SK₁) de chacun des conducteurs de phases (P₁, P₂, P₃) par excitation du premier commutateur électromécanique (R₁) et saisie des tensions (U₁, U₂, U₃) sur les conducteurs de phases (P₁, P₂, P₃) après un laps de temps prédéterminé ;
- contrôle de la présence d'une tension alternative par saisie et comparaison de valeurs (Uₙ, Un₊₁) de tensions (U₁, U₂, U₃) saisies successivement dans le temps sur les conducteurs de phases (P₁, P₂, P₃) ;
- démarrage de l'onduleur (WR) si toutes les étapes de contrôle précitées ont été terminées avec succès,
- génération d'un signal d'erreur, si l'une des étapes de contrôle précitées n'a pas été terminée avec succès.

10. Procédé de contrôle du fonctionnement de commutateurs électromécaniques (R₁, R₂) dans un circuit de commutation selon la revendication 1, sachant que le dispositif de commande (ST) commande le déroulement du contrôle. Suivant, avant le démarrage du l'onduleur (WR)
- déconnexion du premier contact de commutation (SK₁) de chacun des conducteurs de phases (P₁, P₂, P₃) par terminaison de l'excitation du premier commutateur électromécanique (R₁) et saisie des tensions (U₁, U₂, U₃) sur les conducteurs de phases (P₁, P₂, P₃) après un laps de temps prédéterminé.
- contrôle de l'absence d'une tension alternative par saisie et comparaison de valeurs (Uₙ, Un₊₁) de tensions (U₁, U₂, U₃) saisies successivement dans le temps sur les conducteurs de phases (P₁, P₂, P₃) ;
- connexion du premier contact de commutation (SK₁) de chacun des conducteurs de phases (P₁, P₂, P₃) par excitation du premier commutateur électromécanique (R₁) et saisie des tensions (U₁, U₂, U₃) sur les conducteurs de phases (P₁, P₂, P₃) après un laps de temps prédéterminé,
- contrôle de la présence d'une tension alternative par saisie et comparaison de valeurs (Uₙ, Un₊₁) de tensions (U₁, U₂, U₃) saisies successivement dans le temps sur les conducteurs de phases (P₁, P2, P3),
- déconnexion d'un deuxième contact de commutation (SK₂) de chacun des conducteurs de phases (P₁, P₂, P₃) par terminaison de l'excitation d'un deuxième commutateur électromécanique (R₂) et saisie des tensions (U₁, U₂, U₃) sur les conducteurs de phases (P₁, P₂, P₃) après un laps de temps prédéterminé.
- contrôle de l'absence d'une tension alternative par saisie et comparaison de valeurs (Uₙ, Un₊₁) de tensions (U₁, U₂, U₃) saisies successivement dans le temps sur les conducteurs de phases (P₁, P₂, P₃),
- déconnexion du premier contact de commutation (SK₁) de chacun des conducteurs de phases (P₁, P₂, P₃) par terminaison de l'excitation du premier commutateur électromécanique (R₁),
- génération d'un signal d'erreur, si l'une des étapes du contrôle n'a pas été terminée avec succès,
- en cas d'erreur le dispositif de commande (ST) commande un émetteur de signal (SG) pour la signalisation d'erreurs et mémorise un signal d'erreur dans une mémoire d'erreurs (FS), sachant que, lors de la mémorisation d'un signal d'erreur, le dispositif de commande (ST) ne permet pas un nouveau démarrage de l'onduleur (WR).

11. Procédé de contrôle du fonctionnement de commutateurs électromécaniques (R₁, R₂) dans un circuit de commutation selon la revendication 7, sachant que le dispositif de commande (ST) commande le déroulement du contrôle suivant, après l'arrêt de l'onduleur (WR) :
- commande d'un premier contact de commutation (SKN₁) d'un premier commutateur électromécanique (R₁) et d'un deuxième contact de commutation (SKN₂) d'un deuxième commutateur électromécanique (R2) à l'état ouvert,
- saisie d'une tension (U_{w}) sur une résistance (W₁) du diviseur de tension (SP),
- contrôle si la tension (U_{w}) saisie correspond à la fraction de la tension du circuit intermédiaire (U_{zk}) déterminée par le rapport de division du diviseur de tension (SP),
- modification du rapport de division du diviseur de tension (SP) par connexion supplémentaire d'une résistance (W₃) au moyen d'un commutateur (S) contrôlable,
- saisie de la tension (U_{w}) sur la résistance (W₁) du diviseur de tension (SP),
- contrôle si la tension (U_{w}) saisie correspond à la fraction de la tension du circuit intermédiaire (U_{zk}) déterminée par le rapport de division modifiée du diviseur de tension (SP),
- connexion du premier contact de commutation (SKN₁) par excitation du premier commutateur électromécanique (R₁),
- saisie de la tension (U_{w}) sur la résistance (W₁) du diviseur de tension (SP),
- contrôle si la tension (U_{w}) saisie est inchangée,
- déconnexion du premier contact de commutation (SKN₁) par terminaison de l'excitation du premier commutateur électromécanique (R₁) et connexion du deuxième contact de commutation (SKN₂) par excitation du deuxième commutateur électromécanique (R₂),
- saisie de la tension (U_{w}) sur la résistance (W₁) du diviseur de tension (SP),
- contrôle si la tension (U_{w}) saisie est inchangée,
- connexion du premier contact de commutation (SKN₁) par excitation du premier commutateur électromécanique (R₁),
- saisie de la tension (U_{w}) sur la résistance (W₁) du diviseur de tension (SP),
- contrôle si la tension (U_{w}) saisie présente une valeur, qui est déterminée par le potentiel du point de liaison (VB) du circuit intermédiaire, appliqué sur le raccord central du diviseur de tension (SP),
- mémorisation d'un signal d'erreur si l'une des étapes de contrôle précitées n'a pas été terminée avec succès.
